# EUROPÄISCHE PATENTSCHRIFT

(11) **EP 1 631 988 B1**
(45) Veröffentlichungstag und Bekanntmachung des Hinweises auf die Patenterteilung: **26.01.2011**
(21) Anmeldenummer: 04724568.3
(22) Anmeldetag: 31.03.2004
(51) Int. Cl.: H01L 25/07

(54) **LEISTUNGSHALBLEITERMODUL**
POWER SEMICONDUCTOR MODULE
MODULE SEMI-CONDUCTEUR DE PUISSANCE

(30) Priorität: 10.06.2003 DE 10326176
(43) Veröffentlichungstag der Anmeldung: 08.03.2006
(73) Patentinhaber: Infineon Technologies AG, 85579 Neubiberg (DE)
(72) Erfinder: STOLZE, Thilo, 59759 Arnsberg (DE)
(74) Vertreter: Schmuckermaier, Bernhard
(86) Internationale Anmeldenummer: PCT/EP2004/003375
(87) Internationale Veröffentlichungsnummer: WO 2004/109801

(56) Entgegenhaltungen:
- EP-A- 0 067 575
- EP-A- 0 254 692
- EP-A- 0 762 496
- DE-A- 10 142 971
- DE-A- 10 149 886
- US-B1- 6 297 549

## Beschreibung

Die Erfindung betrifft ein Leistungshalbleitermodul mit einem Substrat, auf dessen Oberseite mindestens ein Halbleiterbauelement angeordnet ist und dessen Unterseite zur Wärmeabfuhr auf ein Kühlelement andrückbar ist, und mit mehreren Andruckelementen, die mechanischen Druck auf verschiedene Substratstellen in Richtung auf das Kühlelement ausüben, wobei die Andruckelemente als integrale Bestandteile eines Gehäuses ausgeformt sind und federnd auf die Substratstellen einwirken.

Die DE 101 42 971 A1 beschreibt ein Leistungshalbleitermodul, das ein mit Halbleiterbauelementen bestücktes Keramik-Substrat enthält. Die Halbleiterbauelemente sind mit Leiterbahnen auf der Substratoberseite kontaktiert, die u.a. zu Kontaktstiften zum externen Anschluss des Moduls führen.

Die Substratunterseite ist kupferkaschiert und fungiert als Wärmeableitköntaktfläche, um beim Betrieb der Halbleiterbauelemente in Form von Wärme auftretende Verlustleistungen an einen Kühlkörper oder ein Kühlelement abführen zu können.

Das Substrat ist von einem (Kunststoff-)Modulgehäuse umgeben und z.B. mittels Schraubverbindungen auf den Kühlkörper gepresst. Zur optimale Wärmeabfuhr ist ein durchgängiger und von Lufteinschlüssen freier Flächenkontakt zwischen Substratunterseite und Kühlkörper erwünscht. Durch den Hochtemperatur-Herstellungsprozess unterliegt das Substrat jedoch aufgrund unterschiedlicher Ausdehnungskoeffizienten von Leiter (z.B. Kupfer) und Substrat (z.B. Keramik) internen mechanischen Spannungen. Diese können sich durch nachfolgende Herstellungsschritte (z.B. Lötvorgänge) noch verstärken. Dadurch ist eine Krümmung des Substrats oft unvermeidbar, so dass die Kontaktfläche zum Kühlkörper nicht plan ausgebildet ist.

Um diesem Problem entgegenzuwirken, sind bei dem aus der DE 101 42 971 A1 bekannten Modul externe oder gehäuseinterne Druckstempel vorgesehen, die von außen aufgebrachten Druck auf verschiedene Punkte oder Stellen des Substrats übertragen, um das Substrat möglichst gleichmäßig auf den Kühlkörper zu pressen. Dies wird dadurch unterstützt, dass das Substrat vorteilhafterweise in mehrere zusammenhängende, begrenzt zueinander relativbewegliche Substratbereiche unterteilt ist.

Vor allem Substrate mit größerer Flächenausdehnung sind jedoch hinsichtlich der an den einzelnen Stellen akzeptablen individuellen Andruckkraft äußerst empfindlich. Daher wurde in der DE 101 49 886 A1 der Weg beschritten, die Andruckelemente federn mit dem Gehäuse zu verbinden, um über die Federkräfte den Anpressdruck besser einstellen zu können.

Ein weiteres Modul ist ausserdem noch bekannt aus U.S.-6.297549.

Dabei erweist es sich aber als problematisch, bei einer größeren Anzahl von individuellen Andruckelementen mit diesen eine - insbesondere im mittleren, inneren Bereich des Substrats - gleichmäßige Druckbeaufschlagung zu realisieren. Wird eine zu große äußere Kraft aufgebracht, führt diese zu lokal zu starken Andrücken mit überhöhtem Druck und der Gefahr eines Bruchs der spröden Keramik. Wird die Andruckkraft dagegen zur Vermeidung von Substratbeschädigungen insgesamt zu klein gewählt, verbleiben Bereiche ohne Körperkontakt mit dem Kühlkörper. Bei einer z.B. über das Modulgehäuse eingeleiteten äußeren Kraft wirken sich Bauteiltoleranzen zusätzlich nachteilig aus, da sie zu unterschiedlich starken Druckbeaufschlagungen der einzelnen Substratstellen führen können.

Der vorliegenden Erfindung liegt daher die Aufgabe zugrunde, ein Leistungshalbleitermodul der eingangs genannten Art dahingehend weiterzubilden, dass kostengünstig ein gleichmäßiger Flächenkontakt der Substratunterseite zum Kühlelement realisierbar ist, wobei die individuellen Druckbeaufschlagungen der einzelnen Substratstellen im wesentlichen gleich und von Bauteiltoleranzen unbeeinflusst sind.

Diese Aufgabe wird erfindungsgemäß bei einem Leistungshalbleitermodul der eingangs genannten Art dadurch gelöst, dass die Andruckelemente an einem ersten Gehäuseteil angeformt sind, das gegenüber einem zweiten Gehäuseteil relativ beweglich ist, und das zweite Gehäuseteil Abstandselemente aufweist, die eine Auflagefläche für das Leistungshalbleitermodul in festem Abstand relativ zu dem Substrat definieren.

Ein erster wesentlicher Aspekt der Erfindung besteht damit darin, dass die individuellen Andruckkräfte über individuell nachgiebige, d.h. elastische, federnde Elemente auf die zu beaufschlagenden Substratstellen aufgebracht werden. Durch den bereitgestellten Federweg können Abstandstoleranzen und Bauteiltoleranzen ausgeglichen werden. Damit wird vorteilhafterweise die jeweilige Substratstelle mit einer zum Flächenkontakt ausreichenden Andruckkraft beaufschlagt, ohne dass - jedenfalls in weiten Toleranzbereichen - die Gefahr der Zerstörung des Substrats besteht.

Eine fertigungstechnisch bedeutsamer Aspekt der Erfindung besteht darin, dass die Andruckelemente als integrale Bestandteile eines Modulgehäuses ausgeformt sind. Dies hat den Vorteil, dass die Andruckelemente mit dem Gehäuse erzeugt und mit diesem einfach montiert werden können.

Ein letzter wesentlicher Aspekt der Erfindung ist schließlich, dass der Abstand des die Abstandselemente beinhaltenden ersten Gehäuseteils zum Substrat durch den zweiten Gehäuseteil fest definiert und eingehalten wird, so dass durch Toleranzen des Modulgehäuses nicht der Abstand verkürzt wird, was zu einem starken Anpressdruck bis zur Zerstörung des Substrats führen könnte.

Die Erfindung betriff ein Leistungshalbleitermodul wie in Anspruch 1.

Bei einer konstruktiv und fertigungstechnisch vorteilhaften Ausgestaltung der Erfindung ist vorgesehen, dass die Andruckelemente stegförmig oder stempelförmig ausgebildet sind und damit einen besonders genau definierten Andruck erzeugen.

Dabei sind bevorzugt die federnden Bereiche von Gehäusebereichen oder Bereichen der Andruckelemente mit Materialausnehmungen oder Materialverdünnungen gebildet.

Im Hinblick auf die Montage und die Herstellung des erfindungsgemäßen Moduls ist bevorzugt vorgesehen, dass das Modulgehäuse nur an zwei gegenüberliegenden Seiten Bereiche zur mechanischen Verbindung mit dem Kühlelement aufweist. Mit diesen - z.B. als Verschraubung realisierten - Verbindungen wird über das Gehäuse die Andruckkraft erzeugt, die über die erfindungsgemäß vorgesehenen einzelnen federnden Andruckelemente mit individuell (je nach Federweg oder Einfederung) veränderlicher Andruckkraft auf die einzelnen Substratstellen wirkt.

Häufig wird eine in engen Toleranzen bemessene Bauhöhe eines Moduls gefordert, so dass beispielsweise aus der Moduloberseite austretende Kontaktstifte einen vorgegebenen Abstand zu modulseitigen Anschlagflächen (z.B. für eine Montageplatine) haben. Dies ist nach dieser Ausgestaltung der Erfindung in einfacher Weise gewährleistet, wobei eine toleranzbehaftete Verformung oder Verschiebung der Andruckelemente bzw. des ersten Gehäuseteils ohne Auswirkungen auf das zweite Gehäuseteil und damit auf die Auflagefläche(n) bleibt.

Besonders vorteilhaft ist die vorliegende Erfindung in Ergänzung der in der DE 101 42 971 A1 beschriebenen Ausgestaltung eines Substrats in Form zusammenhängender, aber in Grenzen zueinander relativbeweglicher Substratbereiche anwendbar.

Die Erfindung wird nachfolgend anhand der in den Figuren der Zeichnung dargestellten Ausführungsbeispiele näher erläutert. Es zeigt:
- Figur 1: ein Ausführungsbeispiel eines erfindungsgemäßen Leistungshalbleitermoduls im Längsschnitt,
- Figur 2: ein erstes Gehäuseteil des Moduls nach Figur 1,
- Figur 3: ein zweites Gehäuseteil des Moduls nach Figur 1 und
- Figur 4: das Modul nach Figur 1 komplettiert mit Anschluss- kontakten in Seitenansicht.

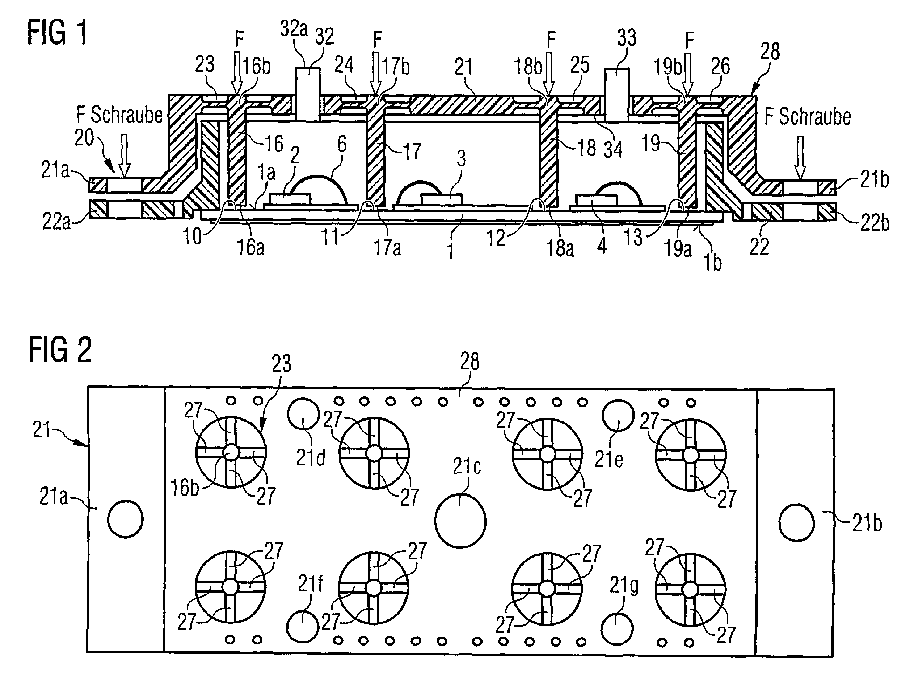

Figur 1 zeigt ein erfindungsgemäßes Leistungshalbleitermodul mit einem Substrat 1 mit einer (kupfer-)kaschierten Oberseite la und (kupfer-)kaschierten einer Unterseite 1b. Auf der Oberseite sind mehrere Leistungs-Halbleiterbauelemente 2, 3, 4 angeordnet und mit nicht näher dargestellten, in der Kaschierung ausgebildeten Leiterbahnen durch Bonddrähte 6 verbunden. An definierten Substratstellen sind - z.T. zwischen den Halbleiterbauelementen - Andruckstellen 10, 11, 12, 13 vorgesehen. Auf diese Stellen werden zur Erzielung eines durchgängigen, luftspaltfreien Flächenkontakts der Substratunterseite 1b mit einem (nicht dargestellten) Kühlelement Druckkräfte zum gleichmäßigen Andruck ausgeübt.

Dazu sind mehrere individuelle Andruckelemente 16, 17, 18, 19 vorgesehen, die steg- oder stempelförmig ausgebildet sind. Die freien Enden 16a, 17a, 18a, 19a der Andruckelemente gelangen bei der weiteren Montage (wie nachfolgend noch beschrieben) in Körperkontakt mit den Andruckstellen 10, 11, 12, 13.

Das Substrat und die Halbleiterbauelemente sind von einem Kunststoffgehäuse 20 umgeben, das von zwei Gehäuseteilen 21, 22 gebildet ist. Das erste Gehäuseteil 21 hat seitliche Flansche 21a, 21b mit je einer Bohrung für eine Schraubverbindung mit dem (nicht dargestellten) Kühlelement. Die Andruckelemente 16, 17, 18, 19 sind als integrale Bestandteile an das Gehäuseteil 21 angeformt, bevorzugt im gemeinsamen Spritzguss mit dem Gehäuseteil zusammen ausgebildet worden, so dass ihre anderen Enden 16b, 17b, 18b, 19b mit dem Gehäuseteil 21 verbunden sind.

Es hat sich gezeigt, dass das Aufbringen einer gemeinsamen äußeren Kraft zum gleichmäßigen Andruck aller Substratstellen problematisch ist. In Folge von Bauteiltoleranzen oder nicht planer Substratbereiche könnten lokal überhöhte Druckkräfte auftreten und zu einer Zerstörung des Substrats führen.

Daher ist vorgesehen, dass die Andruckelemente 16, 17, 18, 19 federnd auf die Andruckstellen 10, 11, 12, 13 wirken. Die Enden 16b, 17b, 18b, 19b der Andruckelemente können dazu über Bereiche 23, 24, 25, 26 mit Materialverdünnung oder Materialausnehmungen mit dem Gehäuseteil 21 verbunden sein. Es ist aber genauso denkbar, die Andruckelemente selbst mit einer Feder zu versehen oder federelastisch auszubilden.

Diese detailliert in Figur 2 gezeigte Ausgestaltung kann z.B. kreuzartige materialverdünnte federnde Stege 27 im Bereich der Gehäusedeckseite 28 umfassen. (In Figur 2 sind insgesamt acht Andruckelemente gezeigt, in der weiteren Beschreibung wird der Einfachheit halber aber nur auf einzelne, auch in Figur 1 im Einzelnen bezeichnete Elemente, z.B. 16, Bezug genommen.) Damit ist das andere Ende (z.B. 16b) jedes Andruckelements (z.B. 16) in vertikaler Richtung federnd gelagert, so dass es bei einem, durch Bauteiltoleranzen oder durch Wölbung der Substratstelle 10 bedingt verminderten Andruckweg entsprechend einfedern kann und somit die auf die Substratstelle 10 ausgeübte Druckkraft nicht übermäßig hoch wird.

Mit anderen Worten: Die elastische Verformung bewirkt eine dosierte, nötigenfalls verminderte Andruckkraft, die auf das Substrat übertragen wird. Die beim Anschrauben der Gehäuseteile entstehende Anpresskraft F_{Schraube} (Figur 1) wird in gewünschter Größenordnung auf die Andruckstellen verteilt. So können auch in der Substratmitte ausreichende Andruckkräfte F realisiert werden, ohne z.B. im äußeren Substratbereich überhöhte Andruckkräfte zu erzeugen.

Wie Figur 1 weiter verdeutlicht, umgibt das Gehäuseteil 21 das zweite, innere Gehäuseteil 22, das flüssigkeitsdicht mit der Substratoberseite 1a verklebt ist und einen dichten Raum bildet, der bedarfsweise mit einer (dielektrischen) Vergussmasse durch eine Füllöffnung 21c (Figur 2) des Gehäuseteils 21 befüllbar ist.

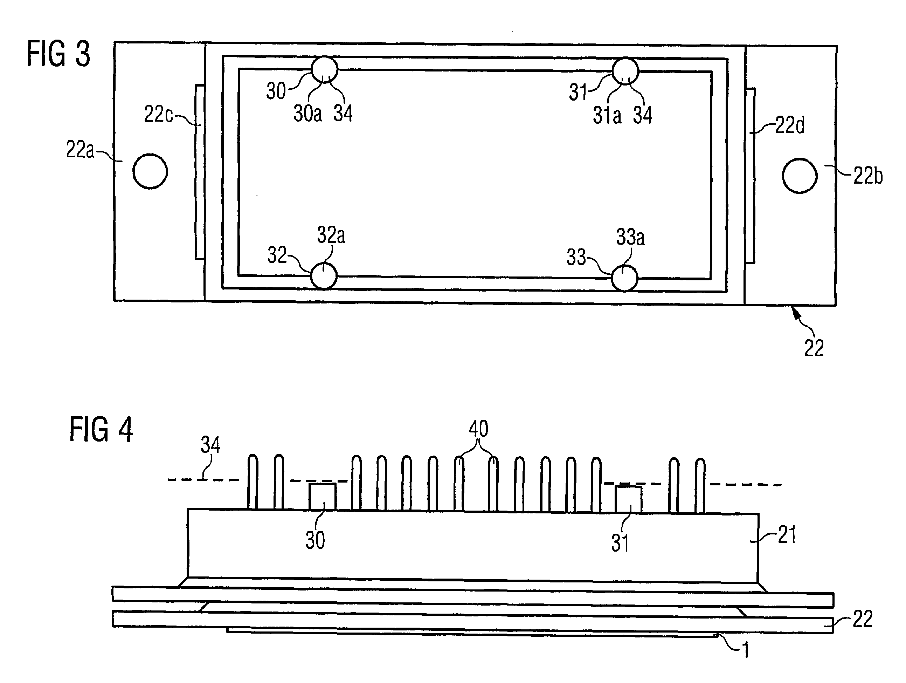

Wie auch Figur 3 zeigt, weist das zweite Gehäuseteil 22 obenseitige Dorne oder Dome 30, 31, 32, 33 auf, die mit ihren Endflächen 30a, 31a, 32a, 33a eine Auflageebene 34 für das Modul definieren. Das Gehäuseteil 22 hat ebenfalls seitliche Flansche 22a, 22b mit je einer Bohrung für eine Schraubverbindung mit dem (nicht dargestellten) Kühlelement. Die Flansche sind durch Fugen oder Schlitze 22c, 22d mechanisch von dem Rest des Gehäuseteils 22 entkoppelt, um die Übertragung etwaiger Spannungen der Schraubverbindung auf das Substrat zu vermeiden.

Wie Figur 2 weiter verdeutlicht, weist das Gehäuseteil 21 neben den Bohrungen in den Flanschen 21a, 21b weitere Öffnungen für Kontaktstifte (Figur 4) und Durchgangsbohrungen 21d, 21,e, 21f, 21g auf, durch die die Dorne 30, 31, 32, 33 längsverschieblich hindurchdringen. Das Gehäuseteil 21 ist so in vertikaler Richtung relativ zu dem Gehäuseteil 22 verschieblich. Das Gehäuseteil 22 ist dagegen relativ zu dem Substrat 1 fixiert, so dass die Auflageebene 34 von etwaigen Verschiebungen des Gehäuseteils 21 unbeeinflusst bleibt und stets eine vorbestimmte Auflage- oder Montagefläche definiert. Somit bleibt die Montagehöhe des Moduls konstant.

Zur Montage werden die Gehäuseteile 21, 22 durch (nicht gezeigte) Schrauben mit dem (nicht dargestellten) Kühlelement verbunden; diese Schraubverbindungen erzeugen die mit F_{Schraube} in Figur 1 bezeichneten Kräfte. Diese Kräfte wirken über die Andruckelemente als Druckkräfte F auf die einzelnen Andruckstellen 10, 11, 12, 13. Die äußere Kraft F_{Schraube} führt zu einem sehr gleichmäßigen Andruck an allen Andruckstellen, weil die federnd wirkenden Andruckelemente 16, 17, 18, 19 Bauteiltoleranzen oder nicht planere Substratoberseiten wie beschrieben weitgehend kompensieren und so eine gleiche Kraft F an allen Stellen ausüben.

Das in Figur 4 gezeigte Modul mit den Gehäuseteilen 21, 22 und dem Substrat 1 ist durch äußere Anschlusskontakte 40 komplettiert, die das Gehäuseteil 21 durchdringen. Die Montagetiefe der Kontakte 40 ist durch die vom Gehäuseteil 21 unabhängige Auflageebene 34 definiert.

### Bezugszeichenliste:

- 1: Substrat
- 1a: Oberseite
- 1b: Unterseite
- 2, 3, 4: Halbleiterbauelemente
- 6: Bonddraht

- 10, 11, 12, 13: Andruckstellen
- 16, 17, 18, 19: Andruckelemente
- 16a, 17a, 18a, 19a: freie Enden
- 16b, 17b, 18b, 19b: anderen Enden

- 20: Kunststoffgehäuse
- 21: Gehäuseteil
- 21a, 21b: seitliche Flansche
- 21c: Füllöffnung
- 21d, 21,e, 21f, 21g: Durchgangsbohrungen
- 22: Gehäuseteil
- 22a, 22b: Flansche
- 22c, 22d: Schlitze
- 23, 24, 25, 26: Bereiche
- 27: federnde Stege
- 28: Gehäusedeckseite

- 30, 31, 32, 33: Dome
- 30a, 31a, 32a, 33a: Endflächen
- 34: Auflageebene

- 40: Anschlusskontakte

- F_{Schraube}: Kräfte
- F: Kräfte

## Patentansprüche

1. Leistungshalbleitermodul
mit einem Substrat(1), auf dessen Oberseite(la) mindestens ein Halbleiterbauelement (2,3, 4) angeordnet ist und dessen Unterseite(1b) zur Wärmeabfuhr auf ein Kühlelement andrückbar ist,
mit mehreren Andruckelementen (16,17, 18,19), die mechanischen Druck (F) auf verschiedene Substratstellen (10, 11,12, 13) in Richtung auf das Kühlelement ausüben,
wobei die Andruckelemente (16,17, 18,19) als integrale Bestandteile eines Gehäuses (21) aus dem gleichen material ausgeformt sind und federnd auf die Substratstellen (10,11,12, 13) einwirken,
**dadurch gekennzeichnet, dass**
die Andruckelemente(16, 17,18, 19) an einem ersten Gehäuseteil (21) angeformt sind, das gegenüber einem zweiten Gehäuseteil (22) relativ beweglich ist, und
das zweite Gehäuseteil (22) Abstandselemente (30,31, 32, 33) aufweist, die eine Auflagefläche (34) für das Leistungshalbleitermodul in festem Abstand relativ zu dem Substrat(1) definieren.

2. Leistungahalbleitermodul nach Anspruch 1,
**dadurch gekennzeichnet, dass** die Andruckelemente (16, 17, 18, 19) stegförmig oder stempelförmig ausgebildet sind.

3. Leistungshalbleitermodul nach Anspruch 1 oder 2,
**dadurch gekennzeichnet, dass** die Andruckelemente (16, 17, 18, 19) über federnde Bereiche (23, 24, 25, 26) mit dem Gehäuse (21) verbunden sind.

4. Leistungshalbleitermodul nach Anspruch 3,
**dadurch gekennzeichnet, dass** die federnden Bereiche (23, 24, 25, 26) von Gehäusebereichen oder Bereichen der Andruckelemente mit Materialausnehmungen oder Materialverdünnungen gebildet sind.

5. Leistungshalbleitermodul nach einem vorherigen Anspruch,
**dadurch gekennzeichnet, dass** das Modulgehäuse (21, 22) nur an zwei gegenüberliegenden Seiten Bereiche (21a, 21b; 22a, 22b) zur mechanischen Verbindung mit dem Kühlelement aufweist.

6. Leistungshalbleitermodul nach einem vorherigen Anspruch,
**dadurch gekennzeichnet, dass** aus der Moduloberseite austretende Kontaktstifte (40) einen vorgegebenen Abstand zu modulseitigen Anschlagflächen (30a, 31a, 32a, 33a) haben.

7. Leistungshalbleitermodul nach einem vorherigen Anspruch,
**dadurch gekennzeichnet, dass** das Substrat (1) in Form zusammenhängender, aber in Grenzen zueinander relativbeweglicher Substratbereiche ausgebildet ist.

## Claims

1. Power semiconductor module
having a substrate (1), on the top side (1a) of which at least one semiconductor component (2, 3, 4) is arranged and the underside (1b) of which can be pressed onto a cooling element for the purpose of dissipating heat, and
having a plurality of contact pressure elements (16, 17, 18, 19) which exert mechanical pressure (F) on various substrate locations (10, 11, 12, 13) in the direction of the cooling element,
the contact pressure elements (16, 17, 18, 19) being formed from the same material as integral parts of a housing (21) and acting in a resilient manner on the substrate locations (10, 11, 12, 13),
**characterized in that**
the contact pressure elements (16, 17, 18, 19) are integrally formed on a first housing part (21) which can be moved relative to a second housing part (22), and
the second housing part (22) has spacer elements (30, 31, 32, 33) which define a bearing area (34) for the power semiconductor module at a fixed distance from the substrate (1).

2. Power semiconductor module according to Claim 1, **characterized in that** the contact pressure elements (16, 17, 18, 19) are in the form of webs or stamps.

3. Power semiconductor module according to Claim 1 or 2, **characterized in that** the contact pressure elements (16, 17, 18, 19) are connected to the housing (21) via resilient regions (23, 24, 25, 26).

4. Power semiconductor module according to Claim 3, **characterized in that** the resilient regions (23, 24, 25, 26) are formed from housing regions or regions of the contact pressure elements having material recesses or thinned sections of material.

5. Power semiconductor module according to a preceding claim,
**characterized in that** the module housing (21, 22) has regions (21a, 21b; 22a, 22b) for mechanical connection to the cooling element only on two opposite sides.

6. Power semiconductor module according to a preceding claim,
**characterized in that** contact pins (40) which emerge from the top side of the module are at a prescribed distance from stop areas (30a, 31a, 32a, 33a) on the module.

7. Power semiconductor module according to a preceding claim,
**characterized in that** the substrate (1) is in the form of substrate regions which are cohesive but can be moved relative to one another within limits.

## Revendications

1. Module de puissance à semiconducteur
comprenant un substrat (1) sur la face (la) supérieure duquel est disposé au moins un composant (2, 3, 4) à semiconducteur, dont la face (1b) inférieure peut, pour évacuer de la chaleur, être pressée sur un élément de refroidissement,
comprenant plusieurs éléments (16, 17, 18, 19) d'application d'une pression, qui appliquent une pression (F) mécanique sur divers points (10, 11, 12, 13) du substrat dans la direction de l'élément de refroidissement,
dans lequel les éléments (16, 17, 18, 19) d'application d'une pression font partie intégrante d'un boîtier (21) en le même matériau et agissent élastiquement sur les points (10, 11, 12, 13) du substrat,
**caractérisé en ce que**
les éléments (16, 17, 18, 19) d'application d'une pression sont formés sur une première partie (21) du boîtier, qui est mobile par rapport à une deuxième partie (22) du boîtier, et
la deuxième partie (22) du boîtier a des éléments (30, 31, 32, 33) d'entretoisement, qui définissent à une distance fixe par rapport au substrat (1) une surface (34) de support du module de puissance à semiconducteur.

2. Module de puissance à semiconducteur suivant la revendication 1,
**caractérisé en ce que** les éléments (16, 17, 18, 19) d'application d'une pression sont constitués sous la forme de barrettes ou de poinçons.

3. Module de puissance à semiconducteur suivant la revendication 1 ou 2,
**caractérisé en ce que** les éléments (16, 17, 18, 19) d'application d'une pression sont reliés au boîtier (21) par des parties (23, 24, 25, 26) élastiques.

4. Module de puissance à semiconducteur suivant la revendication 3,
**caractérisé en ce que** les parties (23, 24, 25, 26) élastiques sont formées de parties de boîtier ou de parties des éléments d'application d'une pression ayant des évidements de matière ou des amincissements de matière.

5. Module de puissance à semiconducteur suivant l'une des revendications précédentes,
**caractérisé en ce que** le boîtier (21, 22) du module a des parties (21a, 21b ; 22a, 22b) de liaison mécanique à l'élément de refroidissement seulement sur deux faces opposées.

6. Module de puissance à semiconducteur suivant l'une des revendications précédentes,
**caractérisé en ce que** des broches (40) de contact sortant de la face supérieure du module sont à une distance prescrite de surface (30a, 31a, 32a, 33a) de butée du côté du module.

7. Module de puissance à semiconducteur suivant l'une des revendications précédentes,
**caractérisé en ce que** le substrat (1) est sous la forme de parties de substrat d'un seul tenant mais mobiles les unes par rapport aux autres dans certaines limites.
